**Europäisches Patentamt**

**European Patent Office**

**Office européen des brevets**

(19)

(11) Veröffentlichungsnummer: **0 072 553**
**B1**

(12) **EUROPÄISCHE PATENTSCHRIFT**

(45) Veröffentlichungstag der Patentschrift:
**11.03.87**

(51) Int. Cl.⁴: **H 03 K 17/60**, H 03 K 17/62

(21) Anmeldenummer: **82107394.7**

(22) Anmeldetag: **13.08.82**

(54) **Gesteuerter Schalter für hochfrequente, gleichstromfreie Signale.**

(30) Priorität: **17.08.81 DE 3132473**

(43) Veröffentlichungstag der Anmeldung:
**23.02.83 Patentblatt 83/8**

(45) Bekanntmachung des Hinweises auf die Patenterteilung:
**11.03.87 Patentblatt 87/11**

(84) Benannte Vertragsstaaten:
**AT BE CH DE FR GB IT LI NL SE**

(56) Entgegenhaltungen:
**DE - A - 1 949 406**
**DE - A - 2 436 255**
**FR - A - 2 366 746**
**US - A - 3 596 110**
**US - A - 3 705 313**
**US - A - 3 873 905**
**US - A - 4 090 124**

(73) Patentinhaber: **Siemens Aktiengesellschaft Berlin und München, Wittelsbacherplatz 2, D-8000 München 2 (DE)**

(72) Erfinder: **Härle, Hans-Georg, Dipl.-Ing., Haldenweg 4, D-8901 Leitershofen (DE)**

## Beschreibung

Die Erfindung betrifft einen gesteuerten Schalter für hochfrequente gleichstromfreie Signale in T-Form mit einer an einen Signaleingang angeschlossenen Reihenschaltung eines Widerstandes und einer Diode im ersten Längszweig, einem ersten Transistor im Querzweig und einem zweiten Transistor im zweiten Längszweig, wobei am Basisanschluss des ersten Transistors eine Steuerspannung anliegen kann und der Kollektoranschluss des ersten Transistors mit der Diode und mit dem Basisanschluss des zweiten Transistors verbunden ist.

In der Nachrichtenübertragungstechnik ist es häufig erforderlich, hochfrequente aber gleichstromfreie Signale ein- bzw. auszuschalten oder umzuschalten. So sind beispielsweise in der Nachrichtenmesstechnik Schalter erforderlich, durch die ein Messgerät an eine Nachrichtenübertragungsstrecke angeschaltet werden kann, ohne dass durch den Schalter das zu untersuchende Signal verfälscht wird. Auch bei der Nachrichtenübertragung ist es notwendig, Umschalteinrichtungen vorzusehen, durch die von einer gestörten auf eine ungestörte Nachrichtenübertragungsstrecke umgeschaltet werden kann. Derartige Umschalter werden häufig mittels zweier gesteuerter Schalter realisiert, von denen der eine ein- und der andere ausgeschaltet wird. Ein Eingangsumschalter für 3 verschiedene frequente Eingangssignale, der aus 3 emittergekoppelten Differenzverstärkern aufgebaut ist, ist aus «Hewlett-Packard-Journal», Februar 1981, S. 13, Fig. 3 bekannt.

Aus der DE-A-2 436 255 ist bereits ein gesteuerter Schalter für hochfrequente gleichstromfreie Signale bekannt, der ebenfalls in T-Form aufgebaut ist. Dieser gesteuerte Schalter enthält im ersten Längszweig eine an einen Signaleingang angeschlossene Reihenschaltung eines Widerstandes und einer Diode, im Querzweig einen ersten Transistor und im zweiten Längszweig einen zweiten Transistor, der mit mindestens einem weiteren Transistor und mit der Serienschaltung aus Widerstand und Diode einen negativen Widerstand bildet. Dieser negative Widerstand ist leerlaufstabil und steuerbar, die Ankopplung bzw. Auskopplung der Signale erfolgt mittels Übertragern.

An gesteuerte Schalter der eingangs erwähnten Art werden eine Reihe von Anforderungen gestellt. Im Hinblick auf den Einsatz bei der Übertragung breitbandiger Signale mit Frequenzen, wie sie beim 140 Mbit/s-Digitalübertragungssystem vorkommen, ist eine hohe Reflexionsdämpfung am Schaltereingang in jedem Schaltzustand erforderlich. Eine hochwertige Signalübertragung bedingt geringe nichtlineare Verzerrungen beim Durchgang des Signals durch den Schalter, wobei jedoch wegen der Verwendung von Verstärkern eine Dämpfung der Signale beim Durchgang durch den Schalter erfolgen kann. Im Bezug auf die Verwendung als Umschalter in Nachrichtenübertragungsstrecken wird ausserdem von derartigen gesteuerten Schaltern gefordert, dass neben einer kurzen Schaltzeit von unter 1 ms eine hohe Sperrdämpfung im abgeschalteten Zustand über einen breiten Frequenzbereich vorhanden sein muss. Im Hinblick auf die Verwendung derartiger Schalter an nicht ohne weiteres zugänglicher Stelle von Nachrichtenübertragungsstrecken wird eine hohe Zuverlässigkeit gefordert. Auch im Hinblick auf die Zuverlässigkeit ist ein geringer Schaltungsaufwand zweckmässig. Schliesslich steht als Forderung, dass die Schalter von nachfolgenden Anordnungen entkoppelt sind.

Die Aufgabe der Erfindung besteht also darin, einen Schalter der eingangs erwähnten Art zu schaffen, der die vorstehend aufgeführten Forderungen erfüllt.

Erfindungsgemäss wird die Aufgabe dadurch gelöst, dass mit dem Signaleingang über einen ersten Koppelkondensator ein erster und ein zweiter Widerstand verbunden sind, dass der andere Anschluss des ersten Widerstandes mit Bezugspotential und der andere Anschluss des zweiten Widerstandes über die Diode mit dem Kollektoranschluss des ersten Transistors und über einen dritten Widerstand mit einer Versorgungsspannung verbunden ist, dass der Basisanschluss des ersten Transistors über einen vierten Widerstand mit der Versorgungsspannung sowie über einen Steuerschalter mit Bezugspotential verbunden ist, dass der Kollektoranschluss des zweiten Transistors mit der Versorgungsspannung und der Emitteranschluss dieses Transistors über einen fünften Widerstand mit Bezugspotential sowie, gegebenenfalls über einen weiteren Koppelkondensator mit dem Ausgangsanschluss verbunden ist und dass als Diode eine PIN-Diode vorgesehen ist.

Im erfindungsgemässen Schalter werden die Forderungen nach hoher Sperrdämpfung und Entkopplung der dem Schalter nachfolgenden Anordnungen in besonders vorteilhafter Weise mit sehr geringem Schaltungsaufwand und geringer Belastung der eingesetzten Bauelemente erfüllt, ausserdem wird in vorteilhafter Weise nur eine einzige Betriebsspannung benötigt.

Im Hinblick auf die Verwendung nur eines Steuerschalters bzw. nur eines Steuersignals ist eine Weiterbildung der Erfindung zweckmässig, bei der der Anschluss des Steuerschalters mit dem Basisanschluss eines dritten Transistors verbunden ist, sowie der Emitteranschluss des dritten Transistors mit Bezugspotential und der Kollektoranschluss dieses Transistors mit dem Basisanschluss des ersten Transistors verbunden ist.

Wegen der geringen Umschaltzeit von etwa 1 μs des erfindungsgemässen gesteuerten Schalters ist dieser besonders vorteilhaft als Eingangsumschalter in einem Übertragungssystem für digitale Signale zu verwenden.

Die Erfindung soll im folgenden anhand der Zeichnungen näher erläutert werden. In der Zeichnung zeigt

Fig. 1 das Schaltbild eines erfindungsgemässen gesteuerten Schalters und

Fig. 2 das Schaltbild eines erfindungsgemässen Umschalters unter Verwendung zweier gesteuerter Schalter nach Fig. 1.

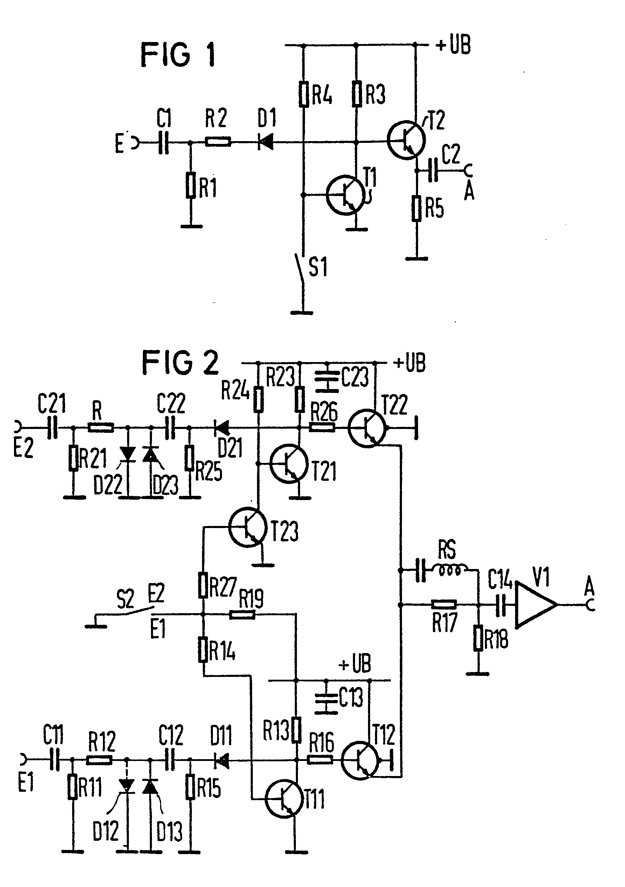

Der in Fig. 1 dargestellte gesteuerte Schalter enthält einen Signaleingang E, an den über einen ersten Koppelkondensator C1 ein erster und ein zweiter Widerstand R1, R2 angeschlossen sind. Während der andere Anschluss des ersten Widerstandes R1 mit Bezugspotential verbunden ist, ist der andere Anschluss des zweiten Widerstandes R2 über eine PIN-Diode D1 mit dem Kollektoranschluss eines ersten Transistors T1 und dem Basisanschluss eines zweiten Transistors T2 verbunden. Der Emitteranschluss des ersten Transistors T1 ist mit Bezugspotential verbunden, der Basisanschluss dieses Transistors ist über einen vierten Widerstand R4 mit Betriebsspannung +Ub und ausserdem über einen ersten Steuerschalter S1 mit Bezugspotential verbunden. Der Basisanschluss des zweiten Transistors T2 ist über einen dritten Widerstand R3 mit Betriebsspannung +Ub verbunden, mit dem Betriebsspannungsanschluss ist ausserdem unmittelbar der Kollektoranschluss des zweiten Transistors T2 verbunden. Der Emitteranschluss dieses Transistors ist über einen fünften Widerstand R5 mit Bezugspotential und über einen zweiten Koppelkondensator C2 mit dem Signalausgang verbunden.

Der gesteuerte Schalter ist entsprechend einem T-Glied mit zwei Ausschaltern im Längszweig und einem Ausschalter im Querzweig aufgebaut. Der erste Widerstand R1 dient dabei zur Leitungsanpassung und damit zur Erhöhung der Reflexionsdämpfung, unabhängig vom jeweiligen Schaltzustand. Der Widerstand R2 bildet mit der in Durchlassrichtung gepolten PIN-Diode D1 und dem dritten Widerstand R3 einen Spannungsteiler für die Eingangssignale, wobei durch den Widerstand R2 das Übertragungsverhalten der PIN-Diode linearisiert wird. Die Ausgangsstufe des gesteuerten Schalters mit dem Transistors T2 ist als Emitterfolger geschaltet. Durch den nicht überbrückten Widerstand R5 ergibt sich eine Gegenkopplung zur Linearisierung der Übertragungseigenschaften des Emitterfolgers. Der Ausschalter im ersten Längszweig des T-Schalters wird also durch die PIN-Diode D1 realisiert, während der Emitterfolger mit dem Transistor T2 den Ausschalter im zweiten Längszweig des T-Schalters darstellt. Der Ausschalter im Querzweig des T-Schalters wird durch den Transistor T1 realisiert.

Die Steuerung aller einzelnen Ausschalter erfolgt über einen ersten Steuerschalter S1, der im eingeschalteten Zustand den Basisanschluss des ersten Transistors T1 mit Bezugspotential verbindet. Damit liegt in diesem Falle am Kollektoranschluss des Transistors T1 eine maximale Kollektorspannung an, während in der anderen Stellung des ersten Steuerschalters S1 der Transistor T1 in die Sättigung gesteuert ist und damit nahezu einen Kurzschluss für die über die Kapazität der jetzt stromlosen, d.h. gesperrten PIN-Diode gelangten Restsignale darstellt.

Der erfindungsgemässe gesteuerte Schalter kann selbstverständlich auch mit komplementären Transistoren und umgepolter PIN-Diode und negativer Betriebsspannung realisiert werden; ausserdem können Bezugspotentiale und Betriebsspannung vertauscht werden.

Der in der Fig. 2 dargestellte Umschalter ist für ein digitales Übertragungssystem mit einer Bitrate von 140 Mbit/s als Eingangsumschalter vorgesehen. Zu diesem Zweck sind zwei gesteuerte Schalter nach Fig. 1 ausgangsmässig zusammengeschaltet. Mit einem ersten Eingang E1 ist ein erster gesteuerter Schalter verbunden, der im Anschluss an einen mit dem Eingang verbundenen Koppelkondensator C11 eine Parallelschaltung aus zwei Widerständen aufweist. Der eine Widerstand R1 ist mit Bezugspotential verbunden und dient als Leitungsabschluss, während der andere Widerstand R12 zur Linearisierung der über einen weiteren Koppelkondensator C12 angeschlossenen PIN-Diode D11 dient. Ausserdem ist mit dem diodenseitigen Ende des Widerstandes R12 ein antiparallel geschaltetes Diodenpaar D12, D13 verbunden, deren andere Anschlüsse mit Bezugspotential verbunden sind und die zusammen mit dem Widerstand R12 als Feinblitzschutz wirken.

Zur Schliessung des Gleichstromweges ist an die Verbindung zwischen weiterem Koppelkondensator C12 und PIN-Diode D11 ein Widerstand R15 angeschaltet, dessen anderer Anschluss mit Bezugpotential verbunden ist. Mit der Anode der PIN-Diode D11 ist der Kollektoranschluss eines Transistors T11, der eine Anschluss eines Widerstandes R13 und der eine Anchluss eines Widerstandes R16 verbunden, dessen anderer Anschluss mit dem Basisanschluss eines weiteren Transistors T12 verbunden ist. Der Emitteranschluss des Transistors T11 ist mit Bezugspotential verbunden, während der Basisanschluss dieses Transistors über einen Widerstand R14 mit einem Steuer-Schalter S2 und über einen Widerstand R18 mit Betriebsspannung +Ub verbunden ist. Mit Betriebsspannung +Ub ist ausserdem der andere Anschluss des Widerstandes R13, der Kollektoranschluss des Transistors T12 sowie ein zusätzlicher Siebkondensator C13 verbunden. Der Emitteranschluss des Transistors T12 ist über eine als Entzerrer wirkende Parallelschaltung aus einem Serienresonanzkreis RS und einem Widerstand R17 mit einem weiteren Koppelkondensator C14 und ausserdem über einen weiteren Widerstand R18 mit Bezugspotential verbunden. An den Kondensator C14 ist ein Verstärker V1 angeschlossen, dessen Ausgangsanschluss den Ausgangsanschluss A des Umschalters darstellt.

Mit dem zweiten Eingang E2 des Umschalters ist ein weiterer gesteuerter Schalter verbunden, dessen Aufbau völlig dem des mit dem ersten Eingang E1 verbundenen gesteuerten Schalters entspricht und dessen Ausgang ebenfalls an den Entzerrer RS, R17, R18 angeschlossen ist. Zur Phasendrehung ist lediglich in die Verbindung vom gesteuerten Schalter zum Transistor T21 neben einem Widerstand R27 ein Transistor T23 eingefügt, dessen Basisanschluss mit dem Widerstand R27, dessen Emitteranschluss mit Bezugspotential und dessen Kollektoranschluss mit dem Basisanschluss des dem Transistor T11 entsprechenden Transistors T21 verbunden ist.

Der andere Anschluss des Steuer-Schalters S2 ist mit Bezugpotential verbunden. Dadurch ist bei geöffnetem Schalter der Signalweg vom Eingang E2 durch den oberen gesteuerten Schalter zum Ausgang A freigegeben, während bei geschlossenem Schalter S2 der Signalweg vom Eingang E1 über den unteren gesteuerten Schalter zum Ausgang A freigegeben ist. Die Funktion der beiden gesteuerten Schalter entspricht völlig der des gesteuerten Schalters nach Fig. 1, im Hinblick auf eine Entzerrung des den Eingängen vorgeschalteten Kabels ist zwischen gesteuertem Schalter und Ausgangsverstärker ein Entzerrer mit einer Durchlassdämpfung von etwa 12 dB vorgesehen. Dieser Entzerrer besteht aus der Parallelschaltung des auf eine Frequenz von etwa 130 MHz abgestimmten Serienresonanzkreises und des Spannungsteilers, der durch den Widerstand R17 sowie durch den Widerstand R18 gebildet wird.

Durch Parallelschaltung weiterer gesteuerter Schalter ist in Analogie zum Umschalter nach Fig. 2 auch ein Multiplexer für eine grössere Anzahl von n Eingangssignalen aufzubauen.

### Patentansprüche

1. Gesteuerter Schalter für hochfrequente gleichstromfreie Signale in T-Form mit einer an einen Signaleingang angeschlossenen Reihenschaltung eines Widerstandes (R2) und einer Diode (D1) im ersten Längszweig, einem ersten Transistor (T1) im Querzweig und einem zweiten Transistor im zweiten Längszweig, wobei am Basisanschluss des ersten Transistors (T1) eine Steuerspannung anliegen kann und der Kollektoranschluss des ersten Transistors (T1) mit der Diode (D1) und mit dem Basisanschluss des zweiten Transistors (T2) verbunden ist, dadurch gekennzeichnet, dass mit dem Signaleingang (E) über einen ersten Koppelkondensator (C1) ein erster und ein zweiter Widerstand (R1, R2) verbunden sind, dass der andere Anschluss des ersten Widerstandes mit Bezugspotential und der andere Anschluss des zweiten Widerstandes über die Diode (D1) mit dem Kollektoranschluss des ersten Transistors (T1) und über einen dritten Widerstand (R3) mit einer Versorgungsspannung (+Ub) verbunden ist, dass der Basisanschluss des ersten Transistors (T1) über einen vierten Widerstand (R4) mit der Versorgungsspannung (+Ub) sowie über einen Steuerschalter (S1) mit Bezugspotential verbunden ist, dass der Kollektoranschluss des zweiten Transistors (T2) mit der Versorgungsspannung (+Ub) und der Emitteranschluss dieses Transistors über einen fünften Widerstand (R5) mit Bezugspotential sowie, gegebenenfalls über einen weiteren Koppelkondensator (C2) mit dem Ausgangsanschluss (A) verbunden ist und dass als Diode (D1) eine PIN-Diode vorgesehen ist.

2. Gesteuerter Schalter nach Patentanspruch 1, dadurch gekennzeichnet, dass der Anschluss des Steuerschalters (S) mit dem Basisanschluss eines dritten Transistors verbunden ist, dass der Emitteranschluss des dritten Transistors mit Bezugspotential und der Kollektoranschluss dieses Transistors mit dem Basisanschluss des ersten Transistors (T1) verbunden ist.

3. Gesteuerter Schalter nach den Ansprüchen 1 oder 2, gekennzeichnet durch seine Verwendung in einem Eingangsumschalter eines Übertragungssystems für digitale Signale, wobei für n Eingangssignal n gesteuerte Schalter vorgesehen sind, deren Eingänge mit jeweils einer Quelle für eines der n Eingangssignale verbunden sind und deren Ausgänge mit einem gemeinsamen Ausgangsanschluss verbunden sind.

### Claims

1. A controlled switch for high-frequency signals having no d.c. component comprising in T-formation a series arrangement of a resistor (R2) and a diode (D1) in the first series arm connected to a signal input, a first transistor (T1) in the shunt arm, and a second transistor in the second series arm, where a control voltage can be connected to the base of the first transistor (T1) and the collector of the first transistor (T1) is connected to the diode (D1) and the base of the second transistor (T2), characterised in that the signal input (E) is connected via a first coupling capacitor (C1) to a first and second resistor (R1, R2), that the other terminal of the first resistor is connected to reference potential and the other terminal of the second resistor is connected via the diode (D1) to the collector of the first transistor (T1) and via a third resistor (R3) to a supply voltage (+Ub), that the base of the first transistor (T1) is connected via a fourth resistor (R4) to the supply voltage (+Ub) and via a control switch (S1) to reference potential, that the collector of the second transistor (T2) is connected to the supply voltage (+Ub) and the emitter of this transistor ist connected via a fifth resistor (R5) to reference potential and possibly via a further coupling capacitor (C2) to the output terminal (A), and that the diode (D1) consists of a PIN-diode.

2. A controlled switch as claimed in Claim 1, characterised in that the terminal of the control switch (S) is connected to the base of a third transistor, that the emitter of the third transistor is connected to reference potential, and the collector of this transistor is connected to the base of the first transistor (T1).

3. A controlled switch as claimed in one of Claims 1 or 2, characterised by its use in an input change-over switch of a transmission system for digital signals, where for n input signals n controlled switches are provided, the inputs of which are each connected to a source for one of the n input signals and the outputs of which are connected to a common output terminal.

### Revendications

1. Commutateur commandé pour des signaux haute fréquence en forme de T et dépourvus de composantes de courant continu, avec un circuit série relié à une entrée des signaux et constitué par une résistance (R2) et par une diode (D1) dans la première branche longitudinale, un premier transistor (T1) dans la branche transversale et un second transistor dans la seconde branche longitudinale une tension de contrôle pouvant être appliquée à la borne de la base du premier transistor (T1), et la borne du collecteur du premier transistor (T1) étant reliée à la diode (D1) et à la borne de la base du second transistor (T2), caractérisé par le fait qu'à l'entrée des signaux (E), et par l'intermédiaire d'un premier condensateur de couplage (T1), sont reliées une première et une seconde résistances (R1, R2), que l'autre borne de la première résistance est portée à un potentiel de référence, que l'autre borne de la seconde résistance est reliée, par l'intermédiaire de la diode (D1), à la borne de collecteur du premier transistor (T1) et, par l'intermédiaire d'une troisième résistance (R3), à une tension d'alimentation (+Ub), que la borne de base du premier transistor (T1) est reliée, par l'intermédiaire d'une quatrième résistance (R4) à la tension d'alimentation (+Ub) ainsi que, par l'intermédiaire d'un commutateur de commande (S1), au potentiel de référence, que la borne de collecteur du second transistor (T2) est reliée à la tension d'alimentation (+Ub) et la borne d'émetteur de ce transistor est reliée, par l'intermédiaire d'une cinquième résistance (R5), au potentiel de référence, ainsi qu'éventuellement et par l'intermédiaire d'un second condensateur de couplage (C2), à la borne de sortie (A), et que comme diode (D1), il est prévu une diode PIN.

2. Commutateur commandé selon la revendication 1, caractérisé par le fait que la borne du commutateur de commande (S) est reliée à la borne de base d'un troisième transistor, que la borne d'émetteur du troisième transistor est portée au potentiel de référence et la borne de collecteur de ce transistor est reliée à la borne de base du premier transistor (T1).

3. Commutateur commandé selon les revendications 1 ou 2, caractérisé par sa mise en œuvre dans un commutateur d'entrée d'un système de transmission pour des signaux numériques, étant noté que pour n signaux d'entrée on prévoit n commutateurs commandés dont les entrées sont respectivement reliées à une source pour l'un des n signaux d'entrée, et dont les sorties sont reliées à une borne de sortie commune.

FIG 1

FIG 2